# EUROPÄISCHE PATENTANMELDUNG

(11) **EP 1 087 439 A2**
(43) Veröffentlichungstag der Anmeldung: **28.03.2001**
(21) Anmeldenummer: 00203247.2
(22) Anmeldetag: 19.09.2000
(51) Int. Cl.: H01L 23/31

(54) **Gleichrichteranordnung für eine Drehstromlichtmaschine eines Kraftfahrzeuges**

(30) Priorität: 27.09.1999 DE 19946255
(71) Anmelder: Philips Corporate Intellectual Property GmbH, 52064 Aachen (DE); Koninklijke Philips Electronics N.V., 5621 BA Eindhoven (NL)
(72) Erfinder: Sommerfeld, Peter, Dipl.-Ing., 52064 Aachen (DE); Rebergen, Hans, Ing., 52064 Aachen (DE); Thor, Volker, Dipl.-ing, 52064 Aachen (DE)
(74) Vertreter: Volmer, Georg, Dipl.-Ing.

(57) **Zusammenfassung**

Um eine Gleichrichteranordnung für eine Drehstromlichtmaschine eines Kraftfahrzeuges mir einem besseren Schurz der Dioden zu schaffen, wird eine Gleichrichteranordnung mit wenigstens einem Kühlkörper (2), mir wenigstens einer auf einem Kühlkörper (2) angeordneten Diode (1), mit wenigstens einer auf der Diode (1) und dem Kühlkörper (2) angeordneten Schutzschicht (7) und mit wenigstens einer Aufnahme (12) an dem Kühlkörper (2) zur Verbindung mit der Schutzschicht (7) vorgeschlagen. Die erfindungsgemäße Gleichrichteranordnung erlaubt den Einsatz von ungehäusten Diodenchips, die erst nach einer Lötung mit Kunststoff als Schutzschicht umgeben werden.

## Beschreibung

Die Erfindung betrifft eine Gleichrichteranordnung für eine Drehstromlichtmaschine eines Kraftfahrzeuges. Bei dem klassischen Prinzip der Drehstromlichtmaschine sind drei gleiche, voneinander unabhängige Windungen u, v, w vorhanden, die räumlich versetzt um 120° angeordnet sind (Stator). Auf dem rotierenden Teil im Inneren (Rotor) sitzt die Erregerwicklung. Sobald ein Erreger-Strom durch die Wicklungen fließt, entsteht ein Magnetfeld, welches wiederum eine dreiphasige Wechselspannung in den Statorwicklungen induziert, die bei Belastung den Drehstrom liefert. Dieser Strom wird mittels einer Brückengleichrichterschaltung gleichgerichtet und dient zur Speisung der Verbraucher und zur Ladung der Batterie. Die Ausgangsspannung der Lichtmaschine wird mittels eines Reglers (Pulsbreitenmodulation des Erregerstromes: PWM) geregelt, d. h. je nach vorhandener Batteriespannung wird der Mittelwert des Erregerstromes eingestellt.

Bekannte elektrische Gleichrichteranordnungen für Kraftfahrzeuganwendungen werden mit speziell gehäusten Dioden aufgebaut, die in metallenen Kühlplatten mechanisch eingepreßt (sog. Press-fit-Dioden) oder auf Kühlplatten aufgelötet werden. Die Ausführung der elektrischen und thermischen Verbindung zwischen Dioden und Kühlkörper (meist eine Kühlplatte als Bauteileträger) ist von besonderer Bedeutung, da aufgrund der hohen elektrischen Ströme (typisch ca. 50 A bis 130 A) in den Dioden die Verlustleistung in den beteiligten Bauteilen ausreichend schnell abgeführt werden muß. Die mechanische Verbindung der üblicherweise 8 Dioden untereinander und die elektrischen Anschlüsse werden meistens durch ein mit Kunststoff umspritztes metallenes Stanzgitter ausgebildet.

Eine sehr gute thermische Verbindung der Dioden zur Kühlplatte, lässt sich durch eine Lötung erzielen. Gehäuste Dioden sind mit einem aushärtenden Kunststoff umgeben, die sich oberhalb einer bestimmten Temperatur zersetzen. Um den Anforderungen der hohen Betriebstemperatur eines Gleichrichters zu genügen, muß für die Verbindung ein höherschmelzendes Weichlot verwendet werden. Der Schmelzpunkt der in Frage kommenden Lote liegt oberhalb der Zersetzungstemperatur des Kunststoffes der gehäusten Dioden.

Somit lassen sich gehäuste Dioden nur bei reduzierten Anforderungen für Gleichrichter verwenden. Bekannte Gleichrichteranordnungen weisen daher meist keine Verkapselung und Verankerung der Gleichrichterdioden auf.

Die Aufgabe der Erfindung ist es daher, eine Gleichrichteranordnung für Drehstromlichtmaschinen für Kraftfahrzeuge zu schaffen, die einen besseren Schutz der Dioden bietet.

Die Aufgabe wird durch ein Gleichrichteranordnung mit wenigstens einem Kühlkörper, mit wenigstens einer auf einem Kühlkörper angeordneten Diode, mit wenigstens einer auf der Diode und dem Kühlkörper angeordneten Schutzschicht und mit wenigstens einer Aufnahme an dem Kühlkörper zur Verbindung mit der Schutzschicht. Die erfindungsgemäße Gleichrichteranordnung erlaubt den Einsatz von ungehäusten Diodenchips, die erst nach einer Lötung mit Kunststoff umgeben werden. Somit erfährt der Kunststoff des Gehäuses keine Behandlung, die oberhalb seiner Zersetzungstemperatur liegt. Die Aufnahme an dem Kühlkörper kann beispielsweise durch eine Vertiefung mit einer Hinterschneidung gebildet werden. Es ist jedoch eine Vielzahl von Befestigungsmöglichkeiten denkbar, die eine einfache und dauerhafte Verbindung bzw. Haftung der Schutzschicht mit dem Kühlkörper bieten. Dabei muß insbesondere die thermische Belastung berücksichtigt werden. Eine Gleichrichteranordnung gemäß der Erfindung benutzt die Kühlplatte des Gleichrichters als konstruktives Teil für das Diodengehäuse. Die Dioden werden auf die Kühlplatten aufgelötet und danach mit ihnen verkapselt. Somit wird die thermische Anbindung optimiert und die Anzahl der Lötstellen minimiert. Dies erhöht die Zuverlässigkeit und Lebensdauer des Gleichrichters.

Bei der Erfindung steht im besonderen die konstruktive Einbindung der Halbleiterdioden des Gleichrichters in den Gesamtaufbau im Vordergrund. Im allgemeinen kann man die Erfindung aber für alle Anwendungen mit Leistungshalbleitern einsetzen.

Im folgenden soll ein Ausführungsbeispiel der Erfindung anhand von Zeichnungen näher erläutert werden. Dabei zeigen
- Figur 1:: eine schematische Darstellung einer Gleichrichteranordnung mit Dioden auf zwei Kühlkörpern und
- Figur 2:: eine schematische Darstellung einer Diode mit auf einem Kühlkörper befestigter Schutzschicht im Querschnitt.

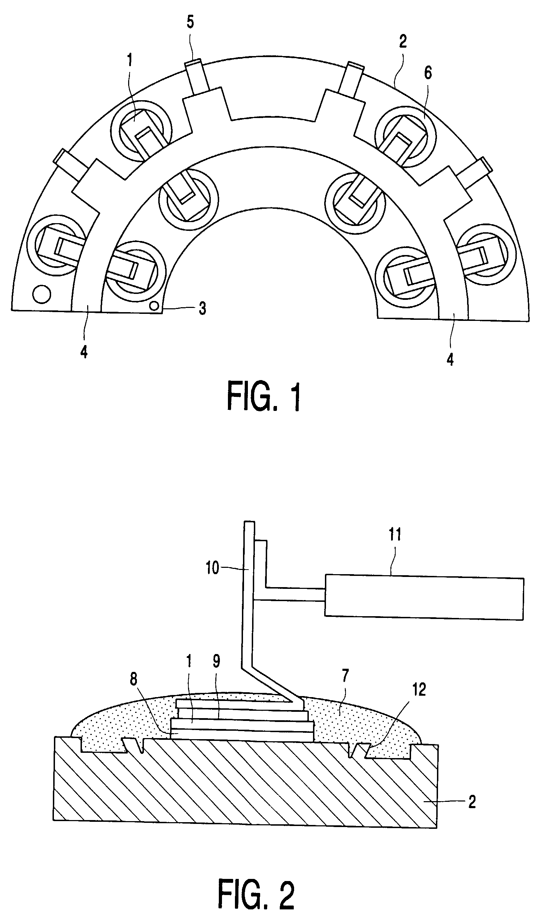

In der Figur 1 ist der Aufbau einer Gleichrichteranordnung mit Dioden 1 auf zwei Kühlkörpern 2 und 3 dargestellt. Die Gleichrichteranordnung besteht aus zwei Kühlplatten 2 und 3 mit einer jeweils gleichen Anzahl von Dioden 1, die über ein elektrisches Verbindungselement 4, welches mehrere Anschlüsse 5 ausbildet, kontaktiert werden. Die Anschlüsse 5 des Verbindungselements 4 zu den Dioden 1 können geschweisst, gelötet oder als Druckkontakte ausgeführt werden. Die Kühlplatten 2 und 3 sind im Bereich der Diodenanbindung 6 so strukturiert, daß die Verkapselung sich mechanisch verankern kann. So erhält man einen Schutz des gesamten Diodenaufbaus gegen mechanische Spannungen bei Temperaturwechseln.

Eine detailliertere Darstellung einer Diode 1 mit auf einem Kühlkörper 2 befestigter Schutzschicht 7 ist in der Figur 2 im Querschnitt gezeigt. Der Halbleiterchip 1 ist zwischen zwei Metallanschlüsse 8 und 9 (z.B. Kupfer) gelötet, die die oberen und unteren Kontaktflächen ausbilden. Der untere Anschluss 8 wird ganzflächig auf die ggfs. oberflächenmetallisierte Kühlplatte 2 gelötet. Der obere Anschluss 9 wird bei Dioden mit Mesastruktur der Diodenmetallisierung flächig angepasst und verhindert so das Auftreten von Kurzschlüssen. Auf den oberen Anschluss 9 kann ein Stift 10 aufgelötet werden, der den Kontakt zu dem elektrischen Verbindungselement 11 herstellt. Die Kühlplatte 2 ist um den Anbindungsbereich der Diode 1 strukturiert. Die Struktur sollte Vertiefungen, möglichst mit Hinterschneidungen, aufweisen, die als Verankerung 12 für eine Verkapselung 7 dienen soll. Diese Struktur kann durch mehrere Stanz-, Preß- und Tiefziehverfahren hergestellt werden. Die Diode 1 ist durch einen Hartverguß 7 umgeben, der auch in die Hinterschneidungen fließt, und sich nach dem Aushärten dort verankert. Dieser Verguß 7 sorgt durch allseitigen Druck (durch das Erkalten nach dem Aushärten bei erhöhter Temperatur) für die Entlastung von mechanischen Spannungen aller im Aufbau befindlichen Lötstellen, da er direkt an der Kühlplatte 2 angreift. Er schützt zusätzlich die Diode 1 gegen äußere Einflüsse.

## Patentansprüche

1. Gleichrichteranordnung für eine Lichtmaschine eines Kraftfahrzeuges
- mit wenigstens einem Kühlkörper (2),
- mit wenigstens einer auf einem Kühlkörper (2) angeordneten Diode (1),
- mit wenigstens einer auf der Diode (1) und dem Kühlkörper (2) angeordneten Schutzschicht (7),
- mit wenigstens einer Aufnahme (12) an dem Kühlkörper (2) zur Verbindung mit der Schutzschicht (7).
